# EUROPÄISCHE PATENTANMELDUNG

(11) **EP 3 796 763 A1**
(43) Veröffentlichungstag der Anmeldung: **24.03.2021**
(21) Anmeldenummer: 19198070.5
(22) Anmeldetag: 18.09.2019
(51) Int. Cl.: H05K 7/14

(54) **FLEXIBEL GESTALTBARE UMRICHTEREINHEITEN**

(71) Anmelder: Siemens Aktiengesellschaft, 80333 München (DE)
(72) Erfinder: Nieberlein, Klaus, 90471 Nürnberg (DE); Baumann, Falko, 91242 Ottensoos (DE); Junghänel, René, 91054 Erlangen (DE); Lautner, Jennifer, 90765 Fürth (DE); Nährig, Matthias, 91085 Weisendorf (DE); Schmenger, Jens, 91088 Bubenreuth (DE)

(57) **Zusammenfassung**

Eine Umrichtereinheit weist eine Hauptplatine (8) auf, auf der mindestens ein Funktionsmodul (1, 5) angeordnet ist. Mittels des Funktionsmoduls (1, 5) ist mindestens eine dem Funktionsmodul (1, 5 über erste Leistungsanschlüsse (2, 7) des Funktionsmoduls (1, 5) zugeführte Wechselspannung (L1, L2, L3, U, V, W) in mindestens zwei über zweite Leistungsanschlüsse (3, 6) des Funktionsmoduls (1, 5) abgegebene Gleichspannungspotenziale (U+, U-, U0) wandelbar. Die Hauptplatine (8) weist Leiterbahnen (10, 11, 14, 15) auf, über welche den Steueranschlüssen (12, 13, 16, 17) die Steuersignale (C11 bis C46) zuführbar sind. Die Hauptplatine (8) weist Leiterbahnen (10, 11, 14, 15) auf, die sich von der Steuereinheit (9) zu ersten und zweiten Steueranschlüssen (12, 13, 16, 17) der Hauptplatine (8) erstrecken und über welche die ersten und zweiten Steuersignale (C11 bis C46) den ersten und zweiten Steueranschlüssen (12, 13, 16, 17) zuführbar sind. Das Funktionsmodul (1, 5) ist mit der Hauptplatine (8) zumindest im Bereich der ersten und zweiten Steueranschlüsse (12, 13, 16, 17) zumindest mechanisch verbunden. Es ist jedoch derart ausgebildet, dass es die ersten Steuersignale (C11 bis C16, C31 bis C36) und/oder die zweiten Steuersignale (C21 bis C26, C41 bis C46) nicht verwertet.

## Beschreibung

Die vorliegende Erfindung geht aus von einer Umrichtereinheit,
- wobei die Umrichtereinheit eine Hauptplatine aufweist,
- wobei auf der Hauptplatine mindestens ein Funktionsmodul angeordnet ist,
- wobei mittels des Funktionsmoduls mindestens eine dem Funktionsmodul über erste Leistungsanschlüsse des Funktionsmoduls zugeführte Wechselspannung in mindestens zwei über zweite Leistungsanschlüsse des Funktionsmoduls abgegebene Gleichspannungspotenziale wandelbar ist,
- wobei die Hauptplatine Leiterbahnen aufweist, über welche ersten und zweiten Steueranschlüssen der Hauptplatine erste und zweite Steuersignale zuführbar sind,
- wobei das Funktionsmodul mit der Hauptplatine zumindest im Bereich der ersten und zweiten Steueranschlüsse zumindest mechanisch verbunden ist.

Die vorliegende Erfindung geht weiterhin aus von einer Kombination zweier Umrichtereinheiten,
- wobei die Umrichtereinheiten baugleiche Hauptplatinen aufweisen,
- wobei auf den Hauptplatinen an miteinander korrespondierenden Orten der Hauptplatinen jeweils mindestens ein Funktionsmodul angeordnet ist,
- wobei mittels des jeweiligen Funktionsmoduls mindestens eine dem jeweiligen Funktionsmodul über erste Leistungsanschlüsse des jeweiligen Funktionsmoduls zugeführte jeweilige Wechselspannung in jeweils mindestens zwei über zweite Leistungsanschlüsse des jeweiligen Funktionsmoduls abgegebene Gleichspannungspotenziale wandelbar ist,
- wobei die ersten und zweiten Leistungsanschlüsse der Funktionsmodule baugleich ausgebildet sind und an miteinander korrespondierenden Orten der Funktionsmodule angeordnet sind,
- wobei die Hauptplatinen jeweilige Leiterbahnen aufweisen, über welche jeweilige erste und zweite Steuersignale jeweiligen ersten und zweiten Steueranschlüssen der jeweiligen Hauptplatine zuführbar sind,
- wobei das jeweilige Funktionsmodul mit der jeweiligen Hauptplatine zumindest im Bereich der jeweiligen ersten und zweiten Steueranschlüsse zumindest mechanisch verbunden ist.

Umrichtereinheiten weisen in der Regel eine Mehrzahl von Funktionseinheiten auf, die in Richtung des Hauptenergieflusses gesehen hintereinander angeordnet sind. In der Praxis ergeben sich zumeist sieben hintereinander angeordnete Funktionseinheiten. Die erste Funktionseinheit ist in der Regel an das speisende Versorgungsnetz - meist ein Drehstromnetz - angeschlossen und als EMI-Filter ausgebildet. Hierauf folgt als zweite Funktionseinheit eine Drosseleinheit. Hierauf folgt oftmals als dritte Funktionseinheit eine Einheit, welche Shuntwiderstände zur Messung der eingangsseitigen Ströme. Diese Funktionseinheit kann im Einzelfall aber auch entfallen. Weiterhin kann eine weitere Funktionseinheit vorhanden sein, die einen Chopper enthält. Die nächste Funktionseinheit ist eine Gleichrichtereinheit, die eine Gleichrichtung des zugeführten Stromes vornimmt. Die fünfte Funktionseinheit ist üblicherweise als Gleichspannungsverbindung ausgebildet. Sie kann insbesondere Stützkondensatoren zur Reduzierung der Welligkeit der Gleichspannungspotenziale aufweisen. Die sechste Funktionseinheit ist als Wechselrichtereinheit ausgebildet. Die letzte Funktionseinheit ist an die gespeiste Einrichtung angeschlossen, meist eine elektrische Maschine. Sie ist in der Regel analog zur ersten Funktionseinheit als EMI-Filter ausgebildet.

Für alle diese Funktionseinheiten sind verschiedene Ausgestaltungen bekannt, je nach zu schaltender Spannung, zu schaltendem Strom und anderen Erfordernissen. Im Ergebnis ergibt sich eine große Typenvielfalt an Umrichtereinheiten. Insbesondere für die Gleichrichtereinheit und - wenn auch in geringerem Umfang - auch für die Wechselrichtereinheit sind viele verschiedene Ausgestaltungen bekannt.

Die Umrichtereinheiten sind meist konkret auf die konkret realisierte Ausgestaltung zugeschnitten. Damit ergibt sich eine große Typenvielfalt und hiermit auch ein erheblicher Entwicklungs- und Betreuungsaufwand. Wird beispielsweise ein Schaltungsteil einer Umrichtereinheit modifiziert, der auch in anderen Umrichtereinheiten verwendet wird, müssen die Datenblätter, Wartungsanleitungen usw. aller entsprechenden Umrichtereinheiten aktualisiert werden. Darüber hinaus führt die Typenvielfalt zu erhöhten Produktionskosten. Auch ergibt sich ein hoher Aufwand für die Logistik und für die Lagerhaltung.

Die Aufgabe der vorliegenden Erfindung besteht darin, Möglichkeiten zu schaffen, mittels derer die Typenvielfalt von Umrichtereinheiten deutlich reduziert werden kann.

Die Aufgabe wird zum einen durch eine Umrichtereinheit mit den Merkmalen des Anspruchs 1 gelöst. Eine vorteilhafte Ausgestaltung der Umrichtereinheit ist Gegenstand des abhängigen Anspruchs 2.

Erfindungsgemäß wird eine Umrichtereinheit der eingangs genannten Art dadurch ausgestaltet, dass das Funktionsmodul derart ausgebildet ist, dass es die ersten Steuersignale und/oder die zweiten Steuersignale nicht verwertet.

Die Hauptplatine ist sozusagen, soweit es das Funktionsmodul betrifft, überdimensioniert. Dies ist zwar ein - relativ kleiner - Nachteil, soweit es die konkret realisierte Umrichtereinheit als solche betrifft. Der wesentliche und entscheidende Vorteil liegt aber darin, dass zur Schaffung einer weiteren Umrichtereinheit mit anderer Funktionalität eine völlig baugleiche Hauptplatine verwendet werden kann. Es muss, soweit es die Hardware betrifft, lediglich das Funktionsmodul entsprechend angepasst werden, so dass das entsprechend angepasste Funktionsmodul zumindest einen Teil derjenigen Steuersignale verwertet, die von dem ursprünglichen Funktionsmodul nicht verwertet werden.

Vorzugsweise ist die Steuereinheit, mittels derer die ersten und zweiten Steuersignale für das Funktionsmodul generierbar sind, auf der Hauptplatine selbst angeordnet. In diesem Fall erstrecken sich die Leiterbahnen von der Steuereinheit zu den ersten und zweiten Steueranschlüssen.

Die Aufgabe wird weiterhin durch eine Kombination zweier Umrichtereinheiten mit den Merkmalen des Anspruchs 3 gelöst. Eine vorteilhafte Ausgestaltung der Kombination zweier Umrichtereinheiten ist Gegenstand des abhängigen Anspruchs 4.

Erfindungsgemäß wird eine Kombination zweier Umrichtereinheiten der eingangs genannten Art dadurch ausgestaltet,
- dass das Funktionsmodul der einen Umrichtereinheit derart ausgebildet ist, dass es die jeweiligen ersten Steuersignale und/oder zweiten die jeweiligen zweiten Steuersignale nicht verwertet und
- dass das Funktionsmodul der anderen Umrichtereinheit derart ausgebildet ist, dass es
   -- in dem Fall, dass das Funktionsmodul der einen Umrichtereinheit weder die ihm zuführbaren ersten Steuersignale noch die ihm zuführbaren zweiten Steuersignale verwertet, die ihm zuführbaren ersten Steuersignale und/ oder die ihm zuführbaren zweiten Steuersignale verwertet,
   -- in dem Fall, dass das Funktionsmodul der einen Umrichtereinheit zwar die ihm zuführbaren ersten Steuersignale, aber nicht die ihm zuführbaren zweiten Steuersignale verwertet, zumindest die ihm zuführbaren zweiten Steuersignale verwertet, und
   -- in dem Fall, dass das Funktionsmodul der einen Umrichtereinheit zwar die ihm zuführbaren zweiten Steuersignale, aber nicht die ihm zuführbaren ersten Steuersignale verwertet, zumindest die ihm zuführbaren ersten Steuersignale verwertet.

Dies entspricht genau dem zuvor erläuterten Fall, dass also das Funktionsmodul der einen Umrichtereinheit bestimmte Steuersignale nicht verwertet, während die korrespondierenden Steuersignale von dem Funktionsmodul der anderen Umrichtereinheit verwertet werden.

Vorzugsweise ist auf den Hauptplatinen jeweils eine Steuereinheit angeordnet, mittels derer die jeweiligen ersten und zweiten Steuersignale für das jeweilige Funktionsmodul generierbar sind. In diesem Fall erstrecken sich die Leiterbahnen der jeweiligen Hauptplatine von der jeweiligen Steuereinheit zu den ersten und zweiten Steueranschlüssen der jeweiligen Hauptplatine.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: wesentliche Funktionseinheiten einer Umrichtereinheit,
- FIG 2: eine Hauptplatine,
- FIG 3 bis 6: Gleichrichtereinheiten,
- FIG 7 und 8: Wechselrichtereinheiten,
- FIG 9: mögliche Konfigurationen einer Hauptplatine mit Gleichrichtereinheiten und Wechselrichtereinheiten,
- FIG 10: eine Gleichrichtereinheit,
- FIG 11: eine Wechselrichtereinheit und
- FIG 12: eine Hauptplatine.

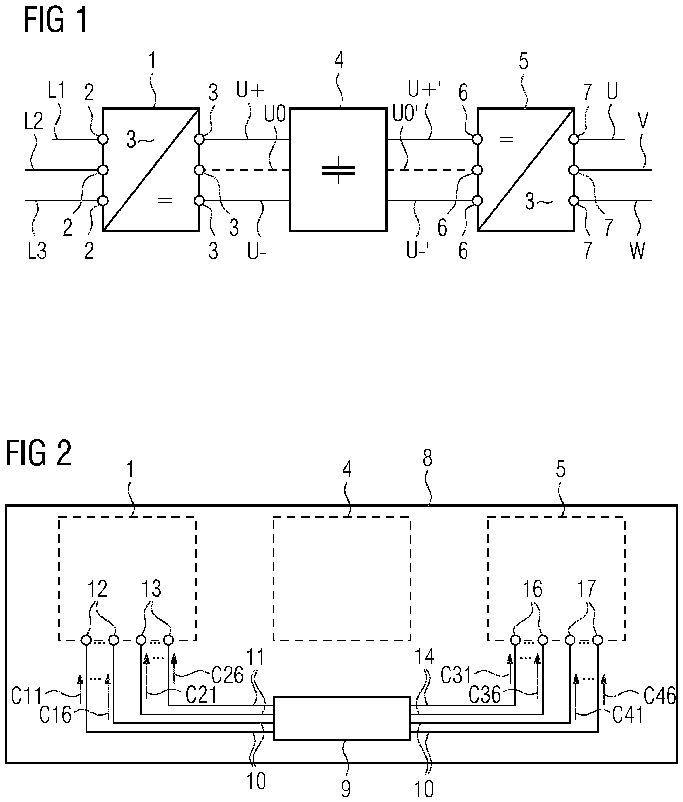

Gemäß FIG 1 weist eine Umrichtereinheit als wesentliche Funktionseinheit zunächst eine Gleichrichtereinheit 1 auf. Der Gleichrichtereinheit 1 werden über erste Leistungsanschlüsse 2 der Gleichrichtereinheit 1 Wechselspannungen L1, L2, L3 (Phasen) zugeführt, in der Regel drei Wechselspannungen eines Drehstromnetzes. Die Gleichrichtereinheit 1 ist in der Lage, die ihr zugeführten Wechselspannungen in mindestens zwei Gleichspannungspotenziale U+, U- zu wandeln. Die Gleichspannungspotenziale U+, U- gibt die Gleichrichtereinheit 1 über zweite Leistungsanschlüsse 3 ab. Mögliche Ausgestaltungen der Gleichrichtereinheit 1 werden später näher erläutert werden.

Die abgegebenen Gleichspannungspotenziale U+, U- werden einer Gleichspannungsverbindung 4 zugeführt. Die Gleichspannungsverbindung 4 ist eine weitere wesentliche Funktionseinheit der Umrichtereinheit. Die Gleichspannungsverbindung 4 weist intern in der Regel ein Kondensatornetzwerk auf, so dass die Gleichspannungspotenziale U+, U- geglättet werden.

Die Gleichspannungspotenziale U+, U- werden einer Wechselrichtereinheit 5 zugeführt. Die Wechselrichtereinheit 5 ist eine weitere wesentliche Funktionseinheit der Umrichtereinheit. Die Wechselrichtereinheit 3 nimmt die Gleichspannungspotenziale U+, U- über zweite Leistungsanschlüsse 6 entgegen. Die Wechselrichtereinheit 5 ist in der Lage, die ihr zugeführten Gleichspannungspotenziale U+, U- in mindestens eine Wechselspannung zu wandeln, in der Regel in drei Wechselspannungen U, V, W (Phasen) eines Drehstromsystems. Die Wechselspannungen U, V, W gibt die Wechselrichtereinheit 5 über erste Leistungsanschlüsse 7 ab.

Die Leistungsanschlüsse 6 der Wechselrichtereinheit 5, über welche die Wechselrichtereinheit 5 die Gleichspannungspotenziale U+, U- entgegennimmt, sind als zweite Leistungsanschlüsse bezeichnet, während die Leistungsanschlüsse 7 der Wechselrichtereinheit 5, über welche die Wechselrichtereinheit 5 die Wechselspannungen U, V, W abgibt, als erste Leistungsanschlüsse bezeichnet sind. Dies hat seinen Grund darin, dass es prinzipiell möglich ist, die Wechselrichtereinheit 5 derart zu betreiben, dass sie mindestens eine ihr zugeführte Wechselspannung U, V, W gleichrichtet. Dies stellt zwar nicht den normalen Betrieb der Wechselrichtereinheit 5 dar, ist aber prinzipiell möglich, sofern die Wechselrichtereinheit 5 entsprechend angesteuert wird. Somit ergibt sich eine einheitliche Verwendung der Terminologie: Die ersten Leistungsanschlüsse 2, 7 sind sowohl bei der Gleichrichtereinheit 1 als auch bei der Wechselrichtereinheit 5 auf der Wechselspannungsseite der jeweiligen Einheit 1, 5 angeordnet, die zweiten Leistungsanschlüsse 3, 6 auf der Gleichspannungsseite.

Gemäß FIG 2 weist die Umrichtereinheit eine Hauptplatine 8 auf. Auf der Hauptplatine 8 ist mindestens ein Funktionsmodul angeordnet. In der Regel sind auf der Hauptplatine 8 mehrere Funktionsmodule angeordnet, nämlich zumindest die Gleichrichtereinheit 1, die Gleichspannungsverbindung 4 und die Wechselrichtereinheit 5. Die entsprechenden Bereiche, an denen die genannten Einheiten 1, 4, 5 angeordnet sind, sind in FIG 2 gestrichelt eingezeichnet und mit den entsprechenden Bezugszeichen versehen. In diesen Bereichen sind die genannten Einheiten 1, 4 und 5 mit der Hauptplatine 8 zumindest mechanisch verbunden. Auf der Hauptplatine 8 können auch weitere Einheiten angeordnet sein, insbesondere die Einheit, welche zur Messung der eingangsseitigen Ströme dient, und/oder das EMI-Filter zur elektrischen Maschine hin, gegebenenfalls auch die Drosseleinheit und gegebenenfalls sogar das EMI-Filter zum Versorgungsnetz 7. Dies ist im Rahmen der vorliegenden Erfindung jedoch von untergeordneter Bedeutung. Daher wird nachfolgend nicht näher auf diese Einheiten eingegangen. Weiterhin ist es möglich, im Einzelfall auf der Hauptplatine 8 nicht sowohl die Gleichrichtereinheit 1 als auch die Wechselrichtereinheit 5 angeordnet sind, sondern nur entweder die Gleichrichtereinheit 1 oder die Wechselrichtereinheit 5, und zwar mit der oder ohne die Gleichspannungsverbindung 4.

Vorzugsweise ist auf der Hauptplatine 8 eine Steuereinheit 9 angeordnet. Die Steuereinheit 9 kann ebenfalls ein Funktionsmodul der Hauptplatine 8 sein. Alternativ kann es sich um einen integralen Bestandteil der Hauptplatine 8 handeln. Auf der Hauptplatine 8 kann weiterhin eine Stromversorgung und die zugehörige Leitungsführung für die Steuereinheit 9 und gegebenenfalls auch für andere Komponenten der Umrichtereinheit angeordnet sein. Auch kann auf der Hauptplatine 8 die Auswertung von erfassten Messwerten erfolgen. Die Auswertung kann insbesondere durch die Steuereinheit 9 erfolgen. Weiterhin kann die Hauptplatine 8 Schutzschaltungen aufweisen.

Die Steuereinheit 9 ist in der Lage, eine Vielzahl von Steuersignalen C11 bis C16, C21 bis C26 und/oder C31 bis C36 und C41 bis C46 zu generieren. Die Steuersignale C11 bis C16 und C21 bis C26 sind für die Gleichrichtereinheit 1 bestimmt. Die Hauptplatine 8 weist daher Leiterbahnen 10, 11 auf, über welche die Steuersignale C11 bis C16 und C21 bis C26 Steueranschlüssen 12, 13 der Hauptplatine 8 zugeführt werden. Die Leiterbahnen 10, 11 erstrecken sich also, sofern die Steuereinheit 9 auf der Hauptplatine 8 angeordnet ist, von der Steuereinrichtung 9 zu den Steueranschlüssen 12, 13. Die Steueranschlüsse 12, 13 sind in dem Bereich angeordnet, in dem die Gleichrichtereinheit 1 mit der Hauptplatine 8 zumindest mechanisch verbunden ist. Die Steuersignale C31 bis C36 und C41 bis C46 sind für die Wechselrichtereinheit 5 bestimmt. Die Hauptplatine 8 weist daher Leiterbahnen 14, 15 auf, über welche die Steuersignale C31 bis C36 und C41 bis C46 Steueranschlüssen 16, 17 der Hauptplatine 8 zugeführt werden. Die Leiterbahnen 14, 15 erstrecken sich also, sofern die Steuereinheit 9 auf der Hauptplatine 8 angeordnet ist, von der Steuereinrichtung 9 zu den Steueranschlüssen 16, 17. Die Steueranschlüsse 16, 17 sind in dem Bereich angeordnet, in dem die Wechselrichtereinheit 5 mit der Hauptplatine 8 zumindest mechanisch verbunden ist. Sofern auf der Hauptplatine 8 nur die Gleichrichtereinheit 1, nicht aber die Wechselrichtereinheit 5 angeordnet ist, reicht es selbstverständlich aus, wenn die Steuereinheit 9 in der Lage ist, die Steuersignale C11 bis C16 und C21 bis C26, nicht aber die Steuersignale C31 bis C36 und C41 bis C46 zu generieren. Ebenso reicht es selbstverständlich aus, wenn die Steuereinheit 9 in der Lage ist, die Steuersignale C31 bis C36 und C41 bis C46, nicht aber die Steuersignale C11 bis C16 und C21 bis C26 zu generieren, sofern auf der Hauptplatine 8 nur die Wechselrichtereinheit 5, nicht aber die Gleichrichtereinheit 1 angeordnet ist. Ebenso müssen in diesem Fall auch nur die entsprechenden Steueranschlüsse 12, 13 oder 16, 17 und die zugehörigen Leiterbahnen 10, 11 oder 14, 15 vorhanden sein.

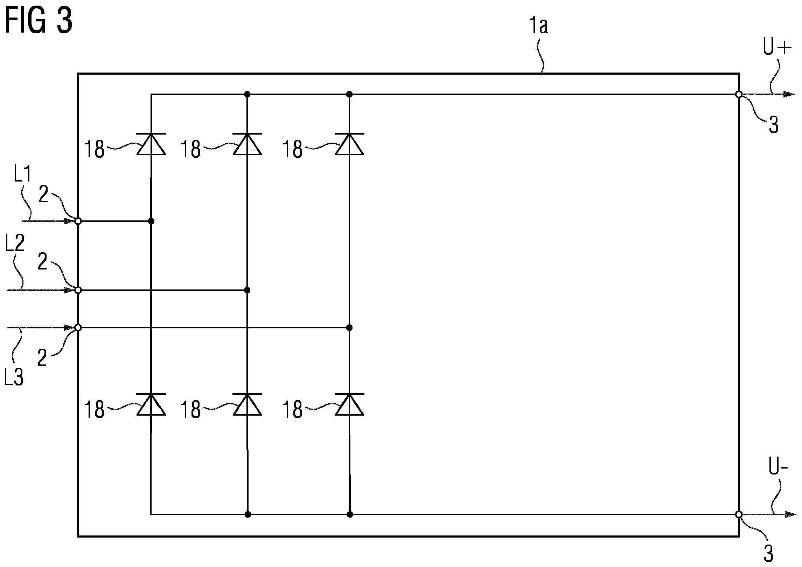

Nachfolgend werden in Verbindung mit den FIG 3 bis 6 mögliche Ausgestaltungen der Gleichrichtereinheit 1 erläutert. Im Rahmen dieser Ausgestaltungen wird das Bezugszeichen für die Gleichrichtereinheit 1 mit einem kleinen Buchstaben a bis d ergänzt, um die verschiedenen Gleichrichtereinheiten 1 bei Bedarf auseinanderhalten zu können. Wenn nachfolgend also nur das Bezugszeichen 1 verwendet wird, so beziehen sich die entsprechenden Aussagen auf beliebige der Gleichrichtereinheiten 1a bis 1d. Wenn konkret beispielsweise das Bezugszeichen 1a verwendet wird, bezieht sich die entsprechende Aussage nur auf die Gleichrichtereinheit 1a. Analoge Aussagen gelten für die Gleichrichtereinheiten 1b, 1c und 1d.

In der Ausgestaltung gemäß FIG 3 weist die Gleichrichtereinheit 1a erste Dioden 18 auf. Mittels der ersten Dioden 18 werden die der Gleichrichtereinheit 1a zugeführten Wechselspannungen L1, L2, L3 gleichgerichtet. Weitere Komponenten sind, soweit es die Gleichrichtung betrifft, nicht vorhanden. Entsprechend der Darstellung in FIG 3 ist die Gleichrichtereinheit 1a also als ungesteuerte Gleichrichtereinheit ausgebildet. Die ersten Dioden 18 sind auch bei den anderen Gleichrichtereinheiten 1b bis 1d vorhanden.

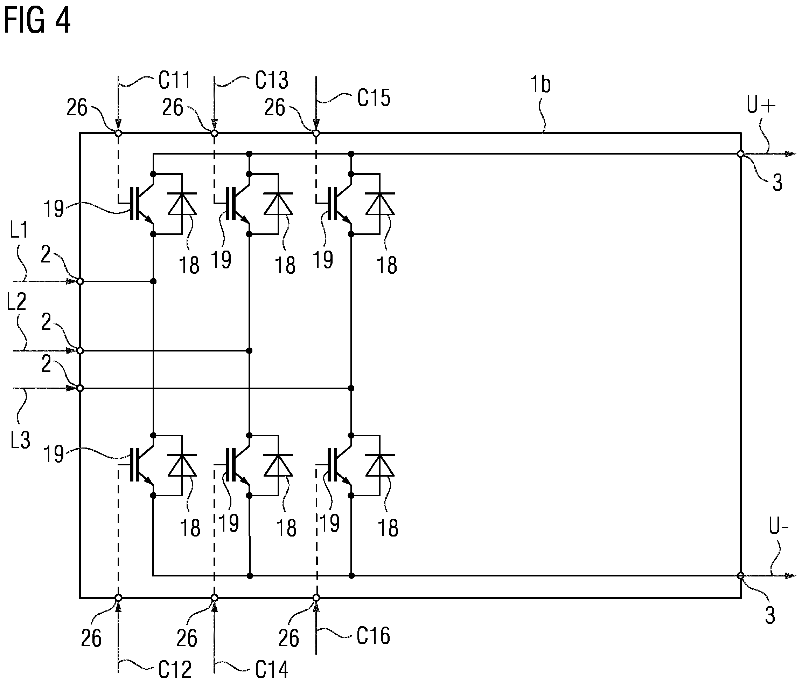

In der Ausgestaltung gemäß FIG 4 weist die Gleichrichtereinheit 1b zusätzlich zu den ersten Dioden 18 erste elektronische Schalter 19 auf (beispielsweise IGBTs oder FETs), die den ersten Dioden 18 parallel geschaltet sind. Die ersten Dioden 18 können in diesem Fall alternativ eigenständige Bauelemente sein oder intrinsische Elemente der ersten elektronischen Schalter 19. Den ersten elektronischen Schaltern 19 werden die Steuersignale C11 bis C16 zugeführt. Die Gleichrichtereinheit 1b weist daher Gegenkontakte 26 auf, die mit den Steueranschlüssen 12 mechanisch und elektrisch verbunden sind. Bei entsprechender Vorgabe der Steuersignale C11 bis C16 durch die Steuereinheit 9 kann die Gleichrichtereinheit 1b somit auch eine Rückspeisung in das Versorgungsnetz vornehmen.

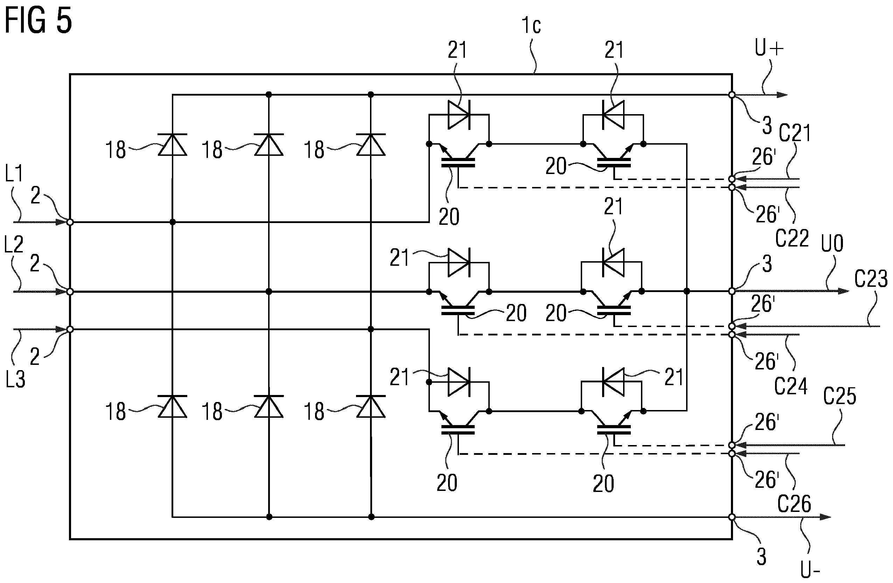

In der Ausgestaltung gemäß FIG 5 weist die Gleichrichtereinheit 1c zusätzlich zu den ersten Dioden 18 zweite elektronische Schalter 20 auf (beispielsweise IGBTs oder FETs). Gegebenenfalls können den zweiten elektronischen Schaltern 20 zweite Dioden 21 parallel geschaltet sein. Die zweiten Dioden 21 können alternativ eigenständige Bauelemente oder intrinsische Elemente der zweiten elektronischen Schalter 20 sein. Den zweiten elektronischen Schaltern 20 werden die Steuersignale C21 bis C26 zugeführt. Die Gleichrichtereinheit 1c weist daher Gegenkontakte 26' auf, die mit den Steueranschlüssen 13 mechanisch und elektrisch verbunden sind. Mittels der zweiten elektronischen Schalter 20 kann die Gleichrichtereinheit 1c somit bei entsprechender Vorgabe der Steuersignale C21 bis C26 durch die Steuereinheit 9 auf der Gleichspannungsseite ein zusätzliches Gleichspannungspotenzial UO bereitstellen. In diesem Fall weist die Gleichrichtereinheit 1c weiterhin einen zusätzlichen zweiten Leistungsanschluss 3 auf, über den das zusätzliche Gleichspannungspotenzial UO abgegeben wird.

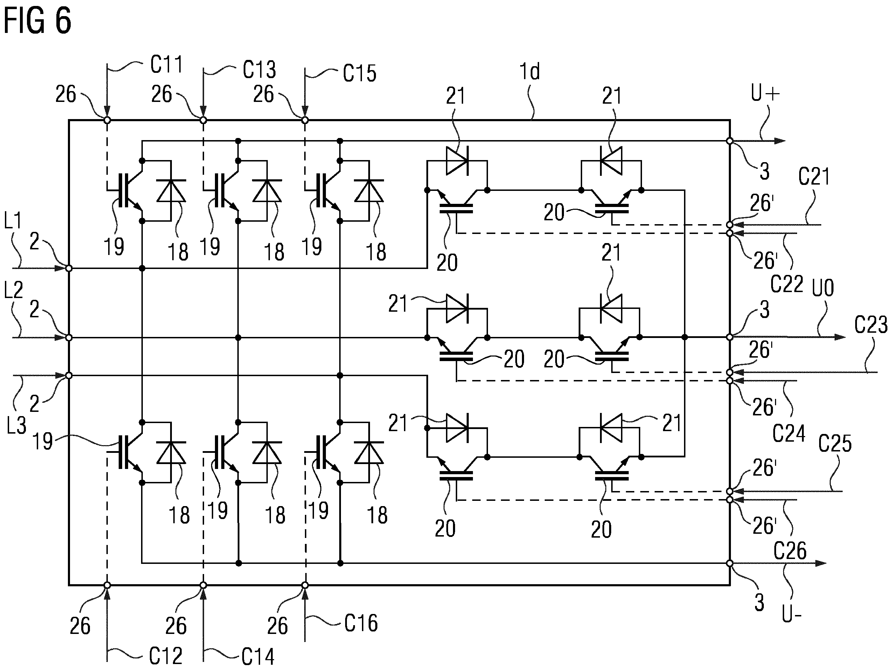

In der Ausgestaltung gemäß FIG 6 weist die Gleichrichtereinheit 1d zusätzlich zu den ersten Dioden 18 sowohl die ersten elektronischen Schalter 19 als auch die zweiten elektronischen Schalter 20 auf. Gegebenenfalls können den zweiten elektronischen Schaltern 20 wieder die zweiten Dioden 21 parallel geschaltet sein. Die Gleichrichtereinheit 1d kombiniert also die zusätzlichen Möglichkeiten der Gleichrichtereinheiten 1b und 1c.

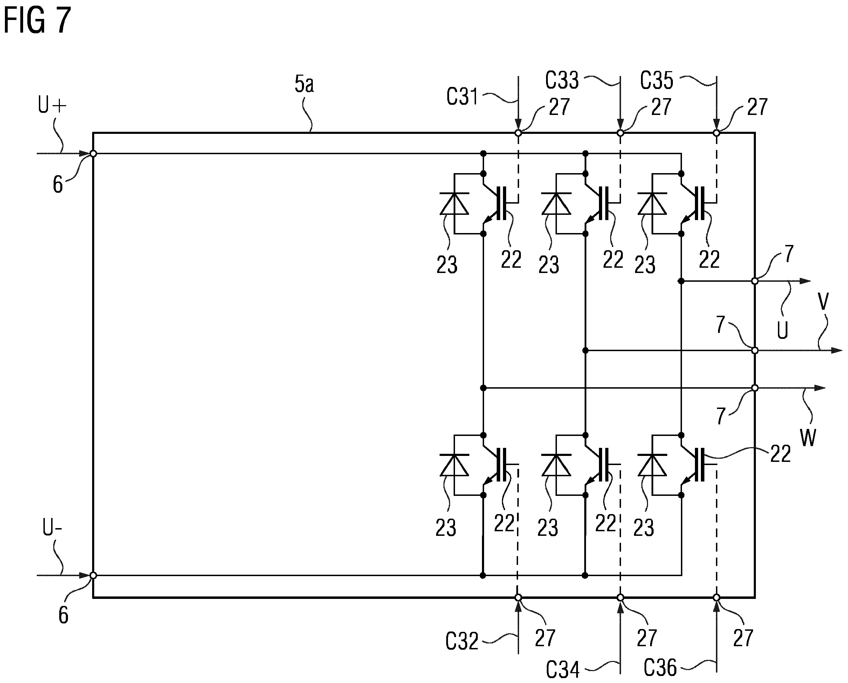

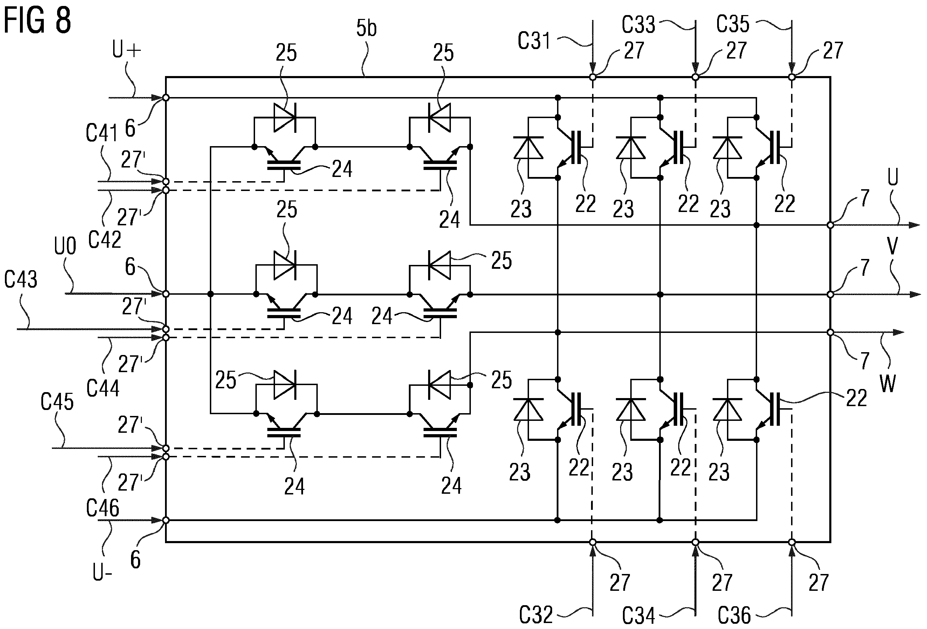

Nachfolgend werden in Verbindung mit den FIG 7 und 8 mögliche Ausgestaltungen der Wechselrichtereinheit 5 erläutert. Im Rahmen dieser Ausgestaltungen wird das Bezugszeichen für die Wechselrichtereinheit 5 mit einem kleinen Buchstaben a und b ergänzt, um die verschiedenen Wechselrichtereinheit 5 bei Bedarf auseinanderhalten zu können. Wenn nachfolgend also nur das Bezugszeichen 5 verwendet wird, so beziehen sich die entsprechenden Aussagen auf beide Wechselrichtereinheiten 5a und 5b. Wenn konkret beispielsweise das Bezugszeichen 5a oder 5b verwendet wird, bezieht sich die entsprechende Aussage nur auf die entsprechende Wechselrichtereinheit 5a bzw. 5b.

In der Ausgestaltung gemäß FIG 7 weist die Wechselrichtereinheit 5a erste elektronische Schalter 22 auf (beispielsweise IGBTs oder FETs). Den ersten elektronischen Schaltern 22 sind erste Dioden 23 parallel geschaltet. Die ersten Dioden 23 können alternativ eigenständige Bauelemente oder intrinsische Elemente der ersten elektronischen Schalter 22 sein. Den ersten elektronischen Schaltern 22 werden die Steuersignale C31 bis C36 zugeführt. Die Wechselrichtereinheit 5a weist daher Gegenkontakte 27 auf, die mit den Steueranschlüssen 16 mechanisch und elektrisch verbunden sind. Je nach Vorgabe der Steuersignale C31 bis C36 durch die Steuereinheit 9 kann die Wechselrichtereinheit 5a somit sowohl einen Stromfluss von der Gleichspannungsseite zur Wechselspannungsseite als auch umgekehrt bewirken. Der Stromfluss von der Gleichspannungsseite zur Wechselspannungsseite stellt den Normalbetrieb der Wechselrichtereinheit 5a dar, der umgekehrte Stromfluss von der Wechselspannungsseite zur Gleichspannungsseite eine Ausnahme.

In der Ausgestaltung gemäß FIG 8 weist die Wechselrichtereinheit 5b zusätzlich zweite elektronische Schalter 24 auf (beispielsweise IGBTs oder FETs). Gegebenenfalls können den zweiten elektronischen Schaltern 24 zweite Dioden 25 parallel geschaltet sein. Die zweiten Dioden 25 können alternativ eigenständige Bauelemente oder intrinsische Elemente der zweiten elektronischen Schalter 24 sein. Den zweiten elektronischen Schaltern 24 werden die Steuersignale C41 bis C46 zugeführt. Die Wechselrichtereinheit 5a weist daher Gegenkontakte 27' auf, die mit den Steueranschlüssen 17 mechanisch und elektrisch verbunden sind. Mittels der zweiten elektronischen Schalter 20 kann die Wechselrichtereinheit 5b somit bei entsprechender Vorgabe der Steuersignale C41 bis C46 durch die Steuereinheit 9 ein auf der Gleichspannungsseite bereitgestelltes zusätzliches Gleichspannungspotenzial UO verwerten oder umgekehrt auf der Gleichspannungsseite ein derartiges zusätzliches Gleichspannungspotenzial UO bereitstellen. In diesem Fall weist die Wechselrichtereinheit 5b weiterhin einen zusätzlichen zweiten Leistungsanschluss 6 auf, über den das zusätzliche Gleichspannungspotenzial UO zugeführt bzw. abgegeben wird.

Von entscheidender Bedeutung ist die Abstimmung der verschiedenen Gleichrichtereinheiten 1a bis 1d aufeinander und der verschiedenen Wechselrichtereinheiten 5a, 5b aufeinander.

Denn der jeweilige interne Aufbau der jeweiligen Gleichrichtereinheit 1a bis 1d ist zwar individuell für die jeweilige Gleichrichtereinheit 1a bis 1d. Hingegen sind die gemeinsamen Schnittstellen nach außen - d.h. die ersten und zweiten Leistungsanschlüsse 2, 3 und die Gegenanschlüsse 26, 26' gleichartig angeordnet und gleichartig ausgebildet. Für die Leistungsanschlüsse 2, 3 kann von jeder der Gleichrichtereinheiten 1a bis 1d ausgegangen werden. Denn die Leistungsanschlüsse 2, 3 sind bei jeder der Gleichrichtereinheiten 1a bis 1d vorhanden. Für die Anordnung der Gegenanschlüsse 26, 26' ist die Gleichrichtereinheit 1d der "Master". Denn die Gleichrichtereinheit 1d verwertet sowohl die Steuersignale C11 bis C16 als auch die Steuersignale C21 bis C26. Sie muss daher sowohl die Gegenanschlüsse 26 als auch die Gegenanschlüsse 26' aufweisen.

Bei der Gleichrichtereinheit 1b sind die Gegenanschlüsse 26 für die Steueranschlüsse 12 an der gleichen Stelle angeordnet wie bei der Gleichrichtereinheit 1d. Auch sind die Gegenanschlüsse 26 für die Steueranschlüsse 12 gleichartig zu den Gegenanschlüssen 26 für die Steueranschlüsse 12 der Gleichrichtereinheit 1d ausgebildet. An denjenigen Stellen, an denen bei der Gleichrichtereinheit 1d die Gegenanschlüsse 26' für die Steueranschlüsse 13 angeordnet sind, sind bei der Gleichrichtereinheit 1b aber entweder gar keine Gegenanschlüsse angeordnet (also auch nicht Gegenanschlüsse für irgendwelche anderen Anschlüsse) oder es sind dort zwar Gegenanschlüsse 26 angeordnet, die dortigen Gegenanschlüsse 26 sind jedoch innerhalb der Gleichrichtereinheit 1b nicht weiter verdrahtet. In jedem Fall verwertet die Gleichrichtereinheit 1b die Steuersignale C21 bis C26 nicht. Dies gilt unabhängig davon, ob die Steuereinheit 9 die Steuersignale C21 bis C26 generiert oder nicht. Falls bei der Gleichrichtereinheit 1b die Gegenanschlüsse 26' für die Steueranschlüsse 13 vorhanden sind, sind sie weiterhin kompatibel zu den Gegenanschlüssen 26' für die Steueranschlüsse 13 der Gleichrichtereinheit 1d ausgebildet.

Die Gleichrichtereinheit 1c ist auf völlig analoge Weise realisiert. Konkret sind bei der Gleichrichtereinheit 1c die Gegenanschlüsse 26' für die Steueranschlüsse 13 an der gleichen Stelle angeordnet wie bei der Gleichrichtereinheit 1d. Auch sind die Gegenanschlüsse 26' für die Steueranschlüsse 12 gleichartig zu den Gegenanschlüssen 26' für die Steueranschlüsse 13 der Gleichrichtereinheit 1d ausgebildet. An denjenigen Stellen, an denen bei der Gleichrichtereinheit 1d die Gegenanschlüsse 26 für die Steueranschlüsse 12 angeordnet sind, sind bei der Gleichrichtereinheit 1c aber entweder gar keine Gegenanschlüsse angeordnet oder es sind dort zwar Gegenanschlüsse 26 angeordnet, die dortigen Gegenanschlüsse 26 sind jedoch innerhalb der Gleichrichtereinheit 1c nicht weiter verdrahtet. In jedem Fall verwertet die Gleichrichtereinheit 1c die Steuersignale C11 bis C16 nicht. Dies gilt unabhängig davon, ob die Steuereinheit 9 die Steuersignale C11 bis C16 generiert oder nicht. Falls bei der Gleichrichtereinheit 1c die Gegenanschlüsse 26 für die Steueranschlüsse 12 vorhanden sind, sind sie kompatibel zu den Gegenanschlüssen 26 für die Steueranschlüsse 12 der Gleichrichtereinheit 1d ausgebildet.

Bei der Gleichrichtereinheit 1a sind die beiden obenstehend für die Gleichrichtereinheiten 1b und 1c realisierten Maßnahmen miteinander kombiniert. Bei der Gleichrichtereinheit 1a können also sowohl die Gegenanschlüsse 26 für die Steueranschlüsse 12 als auch die Gegenanschlüsse 26' für die Steueranschlüsse 13 alternativ vorhanden sein oder nicht vorhanden sein. Sofern die Gegenanschlüsse 26, 26' nicht vorhanden sind, sind an den entsprechenden Stellen überhaupt keine Anschlüsse angeordnet. Sofern die Gegenanschlüsse 26, 26' vorhanden sind, sind sie an der gleichen Stelle angeordnet wie bei der Gleichrichtereinheit 1d und kompatibel zu den Gegenanschlüssen 26, 26' für die Steueranschlüsse 12, 13 der Gleichrichtereinheit 1d ausgebildet. Die Gegenanschlüsse 26, 26' der Gleichrichtereinheit 1a sind jedoch in diesem Fall innerhalb der Gleichrichtereinheit 1a nicht weiter verdrahtet. In jedem Fall verwertet die Gleichrichtereinheit 1a weder die Steuersignale C11 bis C16 noch die Steuersignale C21 bis C26. Dies gilt unabhängig davon, ob die Steuereinheit 9 die Steuersignale C11 bis C16 und/oder die Steuersignale C21 bis C26 generiert oder nicht.

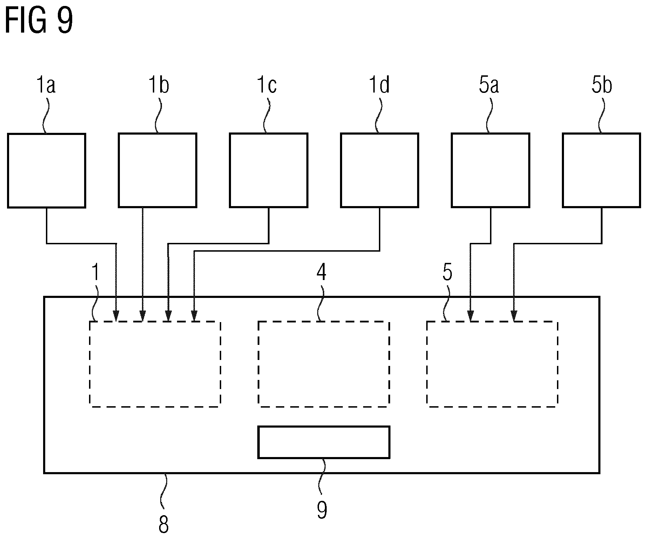

Die Hauptplatine 8 ist, wie bereits erwähnt, derart ausgebildet, dass sie sowohl die Steueranschlüsse 12 als auch die Steueranschlüsse 13 aufweist. Damit ist es entsprechend der Darstellung in FIG 9 möglich, in demjenigen Bereich, in dem die Gleichrichtereinheit 1 angeordnet ist, nach Bedarf die Gleichrichtereinheit 1a, die Gleichrichtereinheit 1b, die Gleichrichtereinheit 1c oder die Gleichrichtereinheit 1d anzuordnen. In jeder dieser Ausgestaltungen ergibt sich - eine ordnungsgemäße Ausgestaltung der übrigen Umrichtereinheit vorausgesetzt - eine funktionsfähige Umrichtereinheit.

Die entsprechenden Ausführungen zu der Abstimmung des Aufbaus der Gleichrichtereinheiten 1a bis 1d ist in analoger Weise auch für die Wechselrichtereinheiten 5a und 5b gültig. Denn der jeweilige interne Aufbau der jeweiligen Wechselrichtereinheit 5a, 5b ist zwar individuell für die jeweilige Wechselrichtereinheit 5a, 5b. Hingegen sind die gemeinsamen Schnittstellen nach außen - d.h. die ersten und zweiten Leistungsanschlüsse 6, 7 und die Gegenanschlüsse 27, 27' für die Steueranschlüsse 16, 17 gleichartig angeordnet. Für die Leistungsanschlüsse 6, 7 kann von jeder der Wechselrichtereinheiten 5a und 5b ausgegangen werden. Denn die Leistungsanschlüsse 6, 7 sind bei jeder der Wechselrichtereinheiten 5a und 5b vorhanden. Für die Anordnung der Gegenanschlüsse 27, 27' ist die Wechselrichtereinheit 5b der "Master". Denn die Wechselrichtereinheit 5b verwertet sowohl die Steuersignale C31 bis C36 als auch die Steuersignale C41 bis C46. Sie muss daher sowohl die Gegenanschlüsse 27 als auch die Gegenanschlüsse 27' aufweisen.

Bei der Wechselrichtereinheit 5a sind die Gegenanschlüsse 27 für die Steueranschlüsse 16 an der gleichen Stelle angeordnet wie bei der Wechselrichtereinheit 5b. Auch sind die Gegenanschlüsse 27 für die Steueranschlüsse 16 gleichartig zu den Gegenanschlüssen 27 für die Steueranschlüsse 16 der Wechselrichtereinheit 5b ausgebildet. An denjenigen Stellen, an denen bei der Wechselrichtereinheit 5b die Gegenanschlüsse 27' für die Steueranschlüsse 17 angeordnet sind, sind bei der Wechselrichtereinheit 5a entweder gar keine Gegenanschlüsse angeordnet (also auch nicht Gegenanschlüsse für irgendwelche anderen Anschlüsse) oder es sind dort zwar Gegenanschlüsse 27' angeordnet, die dortigen Gegenanschlüsse 27' sind jedoch innerhalb der Wechselrichtereinheit 5a nicht weiter verdrahtet. In jedem Fall verwertet die Wechselrichtereinheit 5a die Steuersignale C41 bis C46 nicht. Dies gilt unabhängig davon, ob die Steuereinheit 9 die Steuersignale C41 bis C46 generiert oder nicht. Falls bei der Wechselrichtereinheit 5a die Gegenanschlüsse 27' für die Steueranschlüsse 17 vorhanden sind, sind sie kompatibel zu den Gegenanschlüssen 27' für die Steueranschlüsse 17 der Wechselrichtereinheit 5b ausgebildet.

Die Hauptplatine 8 ist, wie bereits erwähnt, derart ausgebildet, dass sie sowohl die Steueranschlüsse 16 als auch die Steueranschlüsse 17 aufweist. Damit ist es entsprechend der Darstellung in FIG 9 möglich, in demjenigen Bereich, in dem die Wechselrichtereinheit 5 angeordnet ist, nach Bedarf die Wechselrichtereinheit 5a oder die Wechselrichtereinheit 5b anzuordnen. In jeder dieser Ausgestaltungen ergibt sich - eine ordnungsgemäße Ausgestaltung der übrigen Umrichtereinheit vorausgesetzt - eine funktionsfähige Umrichtereinheit.

Unter Verwendung ein und derselben Hauptplatine 8 können also entsprechend der Darstellung in FIG 9 mindestens acht verschiedene Umrichtereinheiten realisiert werden, nämlich in den Kombinationen
Gleichrichtereinheit 1a - Wechselrichtereinheit 5a,
Gleichrichtereinheit 1a - Wechselrichtereinheit 5b,
Gleichrichtereinheit 1b - Wechselrichtereinheit 5a,
Gleichrichtereinheit 1b - Wechselrichtereinheit 5b,
Gleichrichtereinheit 1c - Wechselrichtereinheit 5a,
Gleichrichtereinheit 1c - Wechselrichtereinheit 5b,
Gleichrichtereinheit 1d - Wechselrichtereinheit 5a und
Gleichrichtereinheit 1d - Wechselrichtereinheit 5b.

Anders ausgedrückt: Wenn acht baugleiche Hauptplatinen 8, je zwei der Gleichrichtereinheiten 1a bis 1d und je vier der Umrichtereinheiten 5a und 5b zur Verfügung stehen, kann jede der genannten acht Umrichtereinheiten je einmal hergestellt werden. Die Gleichrichtereinheiten 1a bis 1d sind bei den genannten acht Umrichtereinheiten an miteinander korrespondierenden Orten der Hauptplatinen 8 angeordnet. In analoger Weise sind auch die Wechselrichtereinheiten 5a, 5b an miteinander korrespondierenden Orten der Hauptplatinen 8 angeordnet.

Lediglich die Generierung der Steuersignale C11 bis C46 durch die Steuereinheit 9 muss auf die Verwendung der jeweiligen Gleichrichtereinheit 1a bis 1d und der jeweiligen Wechselrichtereinheit 5a, 5b abgestimmt sein. Dies kann ohne weiteres durch eine entsprechende Programmierung oder Parametrierung der Steuereinheit 9 erreicht werden. In manchen Fällen kann es aber sogar tolerierbar sein, dass von der Steuereinheit 9 Steuersignale C11 bis C46 generiert werden, die von der konkreten Gleichrichtereinheit 1 und/oder von der konkreten Wechselrichtereinheit 5 gar nicht verwertet werden. Hierzu ein Beispiel: Es wird eine Umrichtereinheit mit der Gleichrichtereinheit 1a und der Wechselrichtereinheit 5a implementiert. Die Steuereinheit 9 generiert die Steuersignale C11 bis C16 und C31 bis C36. Dann werden die Steuersignale C11 bis C16 ohne Beeinträchtigung des Funktionalität der Gleichrichtereinheit 1a von der Gleichrichtereinheit 1a ignoriert, während die Wechselrichtereinheit 5a ordnungsgemäß angesteuert wird.

Obenstehend wurden mögliche Ausgestaltungen von Umrichtereinheiten erläutert, bei denen die jeweilige Gleichrichtereinheit 1 in der Lage ist, drei Phasen L1, L2, L3 eines Drehstromsystems gleichzurichten und weiterhin die jeweilige Wechselrichtereinheit 5 zwar normalerweise derart betrieben wird, dass sie mindestens zwei ihr zugeführte Gleichspannungspotenziale U+, U-, UO in drei Phasen U, V, W eines Drehstromsystems umsetzt, prinzipiell aber ebenfalls in der Lage ist, drei Phasen U, V, W eines Drehstromsystems gleichzurichten. Sowohl für die Gleichrichtereinheit 1 als auch für die Wechselrichtereinheit 5 ist jedoch auch möglich, dass auf der jeweiligen Wechselspannungsseite nur ein einzelner erster Leistungsanschluss 2, 7 vorhanden ist. Derartige, auf der Wechselspannungsseite einphasige Ausgestaltungen werden in der Regel realisiert, wenn mittels der Umrichtereinheit höhere Leistungen übertragen werden sollen.

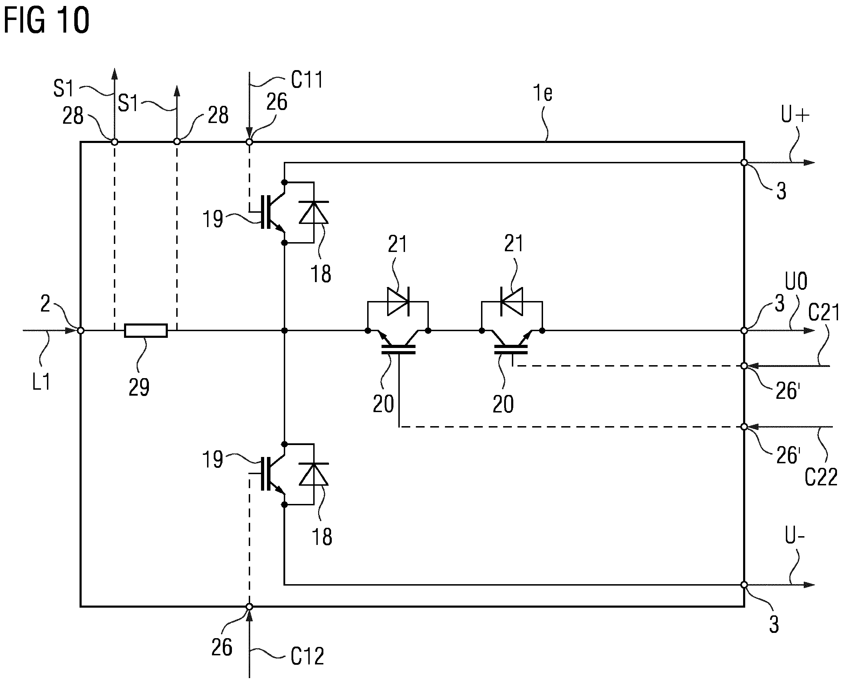

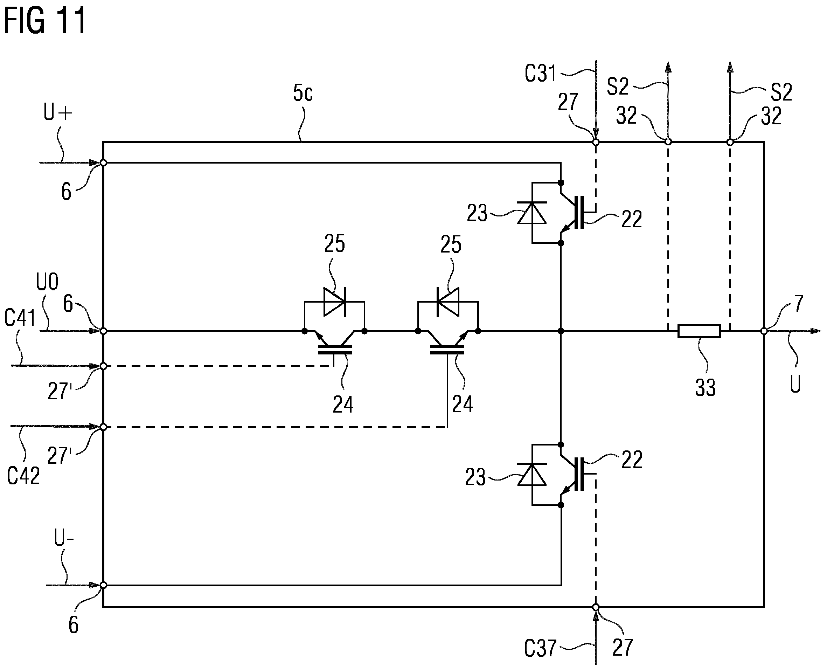

Nachfolgend wird in Verbindung mit den FIG 10 und 11 jeweils eine Ausgestaltung einer derartigen einphasigen Gleichrichtereinheit 1e und eine Ausgestaltung einer derartigen einphasigen Wechselrichtereinheit 5c erläutert, bei denen dies der Fall ist. Die entsprechende einphasige Gleichrichtereinheit 1 wird nachfolgend mit dem Bezugszeichen 1e versehen, die entsprechende einphasige Wechselrichtereinheit 5 mit dem Bezugszeichen 5c.

Weiterhin wird für die Gleichrichtereinheit 1e nur der Fall erläutert, dass sie sowohl die Steuersignale C11 bis C16 als auch die Steuersignale C21 bis C26 verwertet. Die entsprechenden Reduzierungen auf die Verwertung nur der Steuersignale C11 bis C16 oder die Verwertung nur der Steuersignale C21 bis C26 oder die Verwertung weder der Steuersignale C11 bis C16 noch der Steuersignale C21 bis C26 ist völlig analog zu der Vorgehensweise, die obenstehend in Verbindung mit den FIG 3 bis 6 für die dreiphasigen Ausgestaltungen der Gleichrichtereinheit 1 ergriffen wurde. Auch wird für die einphasige Wechselrichtereinheit 5c nur der Fall erläutert, dass sie sowohl die Steuersignale C31 bis C36 als auch die Steuersignale C41 bis C46 verwertet. Die entsprechende Reduzierung auf die Verwertung nur der Steuersignale C31 bis C36 ist völlig analog zu der Vorgehensweise, die obenstehend in Verbindung mit den FIG 7 und 8 für die dreiphasigen Ausgestaltungen der Wechselrichtereinheit 5 ergriffen wurde.

Gemäß FIG 10 weist die einphasige Gleichrichtereinheit 1e erste Dioden 18 auf. Mittels der ersten Dioden 18 wird die der einphasigen Gleichrichtereinheit 1e zugeführte Wechselspannung gleichgerichtet. Weiterhin weist die einphasige Gleichrichtereinheit 1e erste elektronische Schalter 19 auf (beispielsweise IGBTs oder FETs), die den ersten Dioden 18 parallel geschaltet sind. Den ersten elektronischen Schaltern 19 werden alternativ die Steuersignale C11 und C12 oder die Steuersignale C13 und C14 oder die Steuersignale C15 und C16 zugeführt. Bei entsprechender Vorgabe der Steuersignale C11 bis C16 durch die Steuereinheit 9 kann die einphasige Gleichrichtereinheit 1e somit auch eine Rückspeisung in das Versorgungsnetz vornehmen. Weiterhin weist die einphasige Gleichrichtereinheit 1e zusätzlich zweite elektronische Schalter 20 auf (beispielsweise IGBTs oder FETs). Gegebenenfalls können den zweiten elektronischen Schaltern 20 zweite Dioden 21 parallel geschaltet sein. Den zweiten elektronischen Schaltern 20 werden alternativ die Steuersignale C21 und C22 oder die Steuersignale C23 und C24 oder die Steuersignale C25 und C26 zugeführt. Mittels der zweiten elektronischen Schalter 20 kann somit bei entsprechender Vorgabe der Steuersignale C21 bis C26 durch die Steuereinheit 9 die einphasige Gleichrichtereinheit 1e auf der Gleichspannungsseite ein zusätzliches Gleichspannungspotenzial UO bereitstellen.

Gemäß FIG 11 weist die einphasige Wechselrichtereinheit 5c erste elektronische Schalter 22 auf (beispielsweise IGBTs oder FETs). Den ersten elektronischen Schaltern 22 sind erste Dioden 23 parallel geschaltet. Den ersten elektronischen Schaltern 22 werden alternativ die Steuersignale C31 und C32 oder die Steuersignale C33 und C34 oder die Steuersignale C35 und C36 zugeführt. Je nach Vorgabe der Steuersignale C31 bis C36 durch die Steuereinheit 9 kann die einphasige Wechselrichtereinheit 5c somit sowohl einen Stromfluss von der Gleichspannungsseite zur Wechselspannungsseite als auch umgekehrt bewirken. Weiterhin weist die einphasige Wechselrichtereinheit 5c zusätzlich zweite elektronische Schalter 24 auf (beispielsweise IGBTs oder FETs). Gegebenenfalls können den zweiten elektronischen Schaltern 24 zweite Dioden 25 parallel geschaltet sein. Den zweiten elektronischen Schaltern 24 werden alternativ die Steuersignale C41 und C42 oder die Steuersignale C43 und C44 oder die Steuersignale C45 und C46 zugeführt. Mittels der zweiten elektronischen Schalter 20 kann die einphasige Wechselrichtereinheit 5c somit bei entsprechender Vorgabe der Steuersignale C41 bis C46 durch die Steuereinheit 9 ein auf der Gleichspannungsseite bereitgestelltes zusätzliches Gleichspannungspotenzial UO verwerten oder umgekehrt auf der Gleichspannungsseite ein derartiges Gleichspannungspotenzial UO bereitstellen.

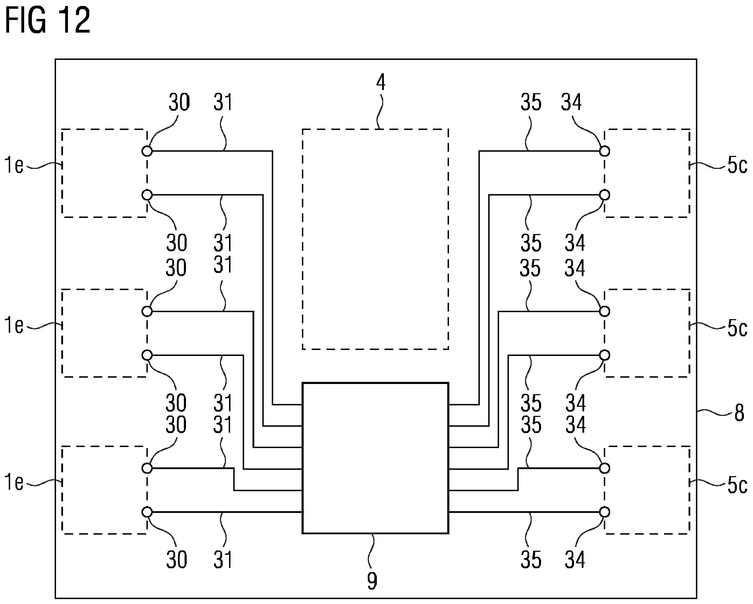

Im Falle der einphasigen Ausgestaltung der Gleichrichtereinheit 1 und/oder der Wechselrichtereinheit 5 sind in der Regel entsprechend der Darstellung in FIG 12 auf der Hauptplatine 8 jeweils drei derartige einphasige Gleichrichtereinheiten 1e bzw. Wechselrichtereinheiten 5c angeordnet, nämlich je eine für die 3 Phasen L1, L2, L3 bzw. U, V, W. Innerhalb derselben Umrichtereinheit und damit auf derselben Hauptplatine 8 sind die einphasigen Gleichrichtereinheiten 1e in aller Regel untereinander gleichartig ausgebildet. Ebenso sind in aller Regel die einphasigen Wechselrichtereinheiten 5c untereinander gleichartig ausgebildet. Von Umrichtereinheit zu Umrichtereinheit hingegen können die einphasigen Gleichrichtereinheiten 1e und/oder die einphasigen Wechselrichtereinheiten 5c durchaus variieren.

Die übrigen Ausführungen, die obenstehend zu den dreiphasigen Ausgestaltungen der Gleichrichtereinheit 1 und der Wechselrichtereinheit 5 bezüglich des internen Aufbaus, bezüglich des Vorhandenseins oder Nichtvorhandenseins und der Anordnung der Gegenanschlüsse 26, 26', 27, 27' und der Verwertung oder Nichtverwertung von Steuersignalen C11 bis C46 und auch der Generierung oder Nichtgenerierung von Steuersignalen C11 bis C46 getroffen wurden, sind in völlig analoger Weise weiterhin anwendbar.

Es ist entsprechend der Darstellung in FIG 10 möglich, dass die einphasige Gleichrichtereinheit 1e Sensoranschlüsse 28 aufweist, über welche (mindestens) ein Sensorsignal S1 abgegeben wird. Beispielsweise kann die einphasige Gleichrichtereinheit 1e einen Shuntwiderstand 29 aufweisen, mittels dessen eine über dem Shuntwiderstand 29 abfallende Spannung und damit der Strom auf der Wechselspannungsseite erfasst wird. Wenn die Sensoranschlüsse 28 vorhanden sind bzw. zumindest in manchen Ausgestaltungen der einphasigen Gleichrichtereinheit 1e vorhanden sein können, weist die Hauptplatine 8 entsprechend der Darstellung in FIG 12 entsprechende Gegenanschlüsse 30 auf. Die Gegenanschlüsse 30 sind zusätzlich zu den Steueranschlüssen 12, 13 vorhanden. Die Leiterbahnen 10, 11 und die Steueranschlüsse 12, 13 sind in FIG 12 nicht mit eingezeichnet, um FIG 10 nicht unnötig zu überfrachten. Sie sind aber vorhanden.

Auch die Gegenanschlüsse 30 sind - analog zu den Steueranschlüssen 12, 13 - in dem Bereich angeordnet, in dem die einphasige Gleichrichtereinheit 1e mit der Hauptplatine 8 zumindest mechanisch verbunden ist. Die Gegenanschlüsse 30 sind in diesem Fall mit der Steuereinheit 9 über Leiterbahnen 31 verbunden. Sofern die Gegenanschlüsse 30 vorhanden sind, können bei einer bestimmten Gleichrichtereinheit 1 die Sensoranschlüsse 28 entweder vorhanden sein oder nicht vorhanden sein. Sofern die Sensoranschlüsse 28 nicht vorhanden sind, sind an den entsprechenden Stellen überhaupt keine Anschlüsse angeordnet. Sofern die Sensoranschlüsse 28 vorhanden sind, sind sie bei allen entsprechenden Gleichrichtereinheiten 1 an der gleichen Stelle angeordnet. Es ist jedoch möglich, dass die Sensoranschlüsse 28 bei manchen Gleichrichtereinheiten 1 innerhalb der jeweiligen Gleichrichtereinheit 1 nicht weiter verdrahtet sind.

Eine analoge Ausgestaltung ist auch bei den dreiphasigen Gleichrichtereinheiten 1a bis 1d und der zugehörigen Hauptplatine 8 möglich. In diesem Fall sind die genannten Ausgestaltungen für jede Phase L1, L2, L3 vorhanden.

In völlig analoger Weise ist es entsprechend der Darstellung in FIG 11 möglich, dass die einphasige Wechselrichtereinheit 5c Sensoranschlüsse 32 aufweist, über welche (mindestens) ein Sensorsignal S2 abgegeben wird. Beispielsweise kann die einphasige Wechselrichtereinheit 5c einen Shuntwiderstand 33 aufweisen, mittels dessen eine über dem Shuntwiderstand 33 abfallende Spannung und damit der Strom auf der Wechselspannungsseite erfasst wird. Wenn die Sensoranschlüsse 32 vorhanden sind bzw. zumindest in manchen Ausgestaltungen der einphasigen Wechselrichtereinheit 5c vorhanden sein können, weist die Hauptplatine 8 entsprechend der Darstellung in FIG 12 entsprechende Gegenanschlüsse 34 auf. Die Gegenanschlüsse 34 sind zusätzlich zu den Steueranschlüssen 16, 17 vorhanden. Die Leiterbahnen 14, 15 und die Steueranschlüsse 16, 17 sind in FIG 12 nicht mit eingezeichnet, um FIG 12 nicht unnötig zu überfrachten. Sie sind aber vorhanden.

Auch die Gegenanschlüsse 34 sind - analog zu den Steueranschlüssen 16, 17 - in dem Bereich angeordnet, in dem die einphasige Wechselrichtereinheit 5c mit der Hauptplatine 8 zumindest mechanisch verbunden ist. Die Gegenanschlüsse 34 sind in diesem Fall mit der Steuereinheit 9 über Leiterbahnen 35 verbunden. Sofern die Gegenanschlüsse 34 vorhanden sind, können bei einer bestimmten Wechselrichtereinheit 5 die Sensoranschlüsse 32 entweder vorhanden sein oder nicht vorhanden sein. Sofern die Sensoranschlüsse 32 nicht vorhanden sind, sind an den entsprechenden Stellen überhaupt keine Anschlüsse angeordnet. Sofern die Sensoranschlüsse 32 vorhanden sind, sind sie bei allen entsprechenden Wechselrichtereinheiten 5 an der gleichen Stelle angeordnet. Es ist jedoch möglich, dass die Sensoranschlüsse 32 bei manchen Wechselrichtereinheit 5 innerhalb der jeweiligen Wechselrichtereinheit 5 nicht weiter verdrahtet sind.

Eine analoge Ausgestaltung ist auch bei den dreiphasigen Wechselrichtereinheiten 5a und 5b und der zugehörigen Hauptplatine 8 möglich. In diesem Fall sind die genannten Ausgestaltungen für jede Phase U, V, W vorhanden.

Es ist möglich, dass die Leistungsströme über die Hauptplatine 8 geführt werden. In diesem Fall sind die Leistungsanschlüsse 2, 3 der Gleichrichtereinheit 1 mit entsprechenden Gegenanschlüssen der Hauptplatine 8 verbunden. Alternativ ist es möglich, dass die Leistungsströme außerhalb der Hauptplatine 8 geführt werden. In diesem Fall sind die Leistungsanschlüsse 2, 3 der Gleichrichtereinheit 1 beispielsweise mit Stromschienen verbindbar oder anderweitig zugänglich. Analoge Ausführungen gelten für die Leistungsanschlüsse 6, 7 der Wechselrichtereinheit 5.

Zusammengefasst betrifft die vorliegende Erfindung somit folgenden Sachverhalt:
Eine Umrichtereinheit weist eine Hauptplatine 8 auf, auf der mindestens ein Funktionsmodul 1, 5 angeordnet ist. Mittels des Funktionsmoduls 1, 5 ist mindestens eine dem Funktionsmodul 1, 5 über erste Leistungsanschlüsse 2, 7 des Funktionsmoduls 1, 5 zugeführte Wechselspannung L1, L2, L3, U, V, W in mindestens zwei über zweite Leistungsanschlüsse 3, 6 des Funktionsmoduls 1, 5 abgegebene Gleichspannungspotenziale U+, U-, UO wandelbar. Die Hauptplatine 8 weist Leiterbahnen 10, 11, 14, 15 auf, über welche den Steueranschlüssen 12, 13, 16, 17 die Steuersignale C11 bis C46 zuführbar sind. Das Funktionsmodul 1, 5 ist mit der Hauptplatine 8 zumindest im Bereich der Steueranschlüsse 12, 13, 16, 17 zumindest mechanisch verbunden. Es ist jedoch derart ausgebildet, dass es die Steuersignale C11 bis C16, C31 bis C36 und/oder die Steuersignale C21 bis C26, C41 bis C46 nicht verwertet.

Die vorliegende Erfindung weist viele Vorteile auf. Insbesondere werden durch die genannten Ausgestaltungen die Entwicklungskosten und auch die Herstellungskosten reduziert. Dennoch kann die volle Flexibilität bei der Gestaltung der Umrichtereinheit erhalten bleiben. Auch der Umfang und die Kosten für die Lagerhaltung von Ersatzteilen können reduziert werden. Diese Vorteile werden insbesondere durch die pinkompatiblen Schnittstellen der Gleichrichtereinheiten 1 und gegebenenfalls auch der Wechselrichtereinheiten 5 erreicht.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Umrichtereinheit,
- wobei die Umrichtereinheit eine Hauptplatine (8) aufweist,
- wobei auf der Hauptplatine (8) mindestens ein Funktionsmodul (1, 5) angeordnet ist,
- wobei mittels des Funktionsmoduls (1, 5) mindestens eine dem Funktionsmodul (1, 5) über erste Leistungsanschlüsse (2, 7) des Funktionsmoduls (1, 5) zugeführte Wechselspannung (L1, L2, L3, U, V, W) in mindestens zwei über zweite Leistungsanschlüsse (3, 6) des Funktionsmoduls (1, 5) abgegebene Gleichspannungspotenziale (U+, U-, UO) wandelbar ist,
- wobei die Hauptplatine (8) Leiterbahnen (10, 11, 14, 15) aufweist, über welche ersten und zweiten Steueranschlüssen (12, 13, 16, 17) der Hauptplatine (8) erste und zweite Steuersignale (C11 bis C46) zuführbar sind,
- wobei das Funktionsmodul (1, 5) mit der Hauptplatine (8) zumindest im Bereich der ersten und zweiten Steueranschlüsse (12, 13, 16, 17) zumindest mechanisch verbunden ist,
**dadurch gekennzeichnet,**
**dass** das Funktionsmodul (1, 5) derart ausgebildet ist, dass es die ersten Steuersignale (C11 bis C16, C31 bis C36) und/ oder die zweiten Steuersignale (C21 bis C26, C41 bis C46) nicht verwertet.

2. Umrichtereinheit nach Anspruch 1,
**dadurch gekennzeichnet,**
**dass** auf der Hauptplatine (8) eine Steuereinheit (9) angeordnet ist, mittels derer die ersten und zweiten Steuersignale (C11 bis C46) für das Funktionsmodul (1, 5) generierbar sind, und dass die Leiterbahnen (10, 11, 14, 15) sich von der Steuereinheit (9) zu den ersten und zweiten Steueranschlüssen (12, 13, 16, 17) erstrecken.

3. Kombination zweier Umrichtereinheiten,
- wobei die Umrichtereinheiten baugleiche Hauptplatinen (8) aufweisen,
- wobei auf den Hauptplatinen (8) an miteinander korrespondierenden Orten der Hauptplatinen (8) jeweils mindestens ein Funktionsmodul (1, 5) angeordnet ist,
- wobei mittels des jeweiligen Funktionsmoduls (1, 5) mindestens eine dem jeweiligen Funktionsmodul (1, 5) über erste Leistungsanschlüsse (2, 7) des jeweiligen Funktionsmoduls (1, 5) zugeführte jeweilige Wechselspannung (L1, L2, L3, U, V, W) in jeweils mindestens zwei über zweite Leistungsanschlüsse (3, 6) des jeweiligen Funktionsmoduls (1, 5) abgegebene Gleichspannungspotenziale (U+, U-, UO) wandelbar ist,
- wobei die ersten und zweiten Leistungsanschlüsse (2, 3, 6, 7) der Funktionsmodule (1, 5) baugleich ausgebildet sind und an miteinander korrespondierenden Orten der Funktionsmodule (1, 5) angeordnet sind,
- wobei die Hauptplatinen (8) jeweilige Leiterbahnen (10, 11, 14, 15) aufweisen, über welche jeweilige erste und zweite Steuersignale (C11 bis C46) jeweiligen ersten und zweiten Steueranschlüssen (12, 13, 16, 17) der jeweiligen Hauptplatine (8) zuführbar sind,
- wobei das jeweilige Funktionsmodul (1, 5) mit der jeweiligen Hauptplatine (8) zumindest im Bereich der jeweiligen ersten und zweiten Steueranschlüsse (12, 13, 16, 17) zumindest mechanisch verbunden ist,
**dadurch gekennzeichnet,**
- **dass** das Funktionsmodul (1, 5) der einen Umrichtereinheit derart ausgebildet ist, dass es die jeweiligen ersten Steuersignale (C11 bis C16, C31 bis C36) und/oder die jeweiligen zweiten Steuersignale (C21 bis C26, C41 bis C46) nicht verwertet und
- **dass** das Funktionsmodul (1, 5) der anderen Umrichtereinheit derart ausgebildet ist, dass es
-- in dem Fall, dass das Funktionsmodul (1, 5) der einen Umrichtereinheit weder die ihm zuführbaren ersten Steuersignale (C11 bis C16, C31 bis C36) noch die ihm zuführbaren zweiten Steuersignale (C21 bis C26, C41 bis C46) verwertet, die ihm zuführbaren ersten Steuersignale (C11 bis C16, C31 bis C36) und/oder die ihm zuführbaren zweiten Steuersignale (C21 bis C26, C41 bis C46) verwertet,
-- in dem Fall, dass das Funktionsmodul (1, 5) der einen Umrichtereinheit zwar die ihm zuführbaren ersten Steuersignale (C11 bis C16, C31 bis C36), aber nicht die ihm zugeführten zweiten Steuersignale (C21 bis C26, C41 bis C46) verwertet, zumindest die ihm zuführbaren zweiten Steuersignale (C21 bis C26, C41 bis C46) verwertet, und
-- in dem Fall, dass das Funktionsmodul (1, 5) der einen Umrichtereinheit zwar die ihm zuführbaren zweiten Steuersignale (C21 bis C26, C41 bis C46), aber nicht die ihm zugeführten ersten Steuersignale (C11 bis C16, C31 bis C36) verwertet, zumindest die ihm zuführbaren ersten Steuersignale (C11 bis C16, C31 bis C36) verwertet.

4. Kombination zweier Umrichtereinheiten nach Anspruch 3, **dadurch gekennzeichnet,**
**dass** auf den Hauptplatinen (8) jeweils eine Steuereinheit (9) angeordnet ist, mittels derer die jeweiligen ersten und zweiten Steuersignale (C11 bis C46) für das jeweilige Funktionsmodul (1, 5) generierbar sind, und dass die Leiterbahnen (10, 11, 14, 15) der jeweiligen Hauptplatine (8) sich von der jeweiligen Steuereinheit (9) zu den jeweiligen ersten und zweiten Steueranschlüssen (12, 13, 16, 17) der jeweiligen Hauptplatine (8) erstrecken.
